(19) **Europäisches Patentamt / European Patent Office / Office européen des brevets**

(11) **EP 1 535 376 B1**

(12) **EUROPÄISCHE PATENTSCHRIFT**

(45) Veröffentlichungstag und Bekanntmachung des Hinweises auf die Patenterteilung:
**29.12.2010   Patentblatt 2010/52**

(51) Int Cl.:
*H01S 5/183* (2006.01)      *H01S 5/04* (2006.01)

(21) Anmeldenummer: **03794787.6**

(22) Anmeldetag: **13.08.2003**

(86) Internationale Anmeldenummer:
**PCT/DE2003/002728**

(87) Internationale Veröffentlichungsnummer:
**WO 2004/025796 (25.03.2004 Gazette 2004/13)**

(54) **OPTISCH GEPUMPTE STRAHLUNGSEMITTIERENDE HALBLEITERVORRICHTUNG UND VERFAHREN ZU DEREN HERSTELLUNG**

OPTICALLY PUMPED SEMICONDUCTOR DEVICE FOR RADIATION EMISSION AND THE PRODUCTION METHOD THEREOF

DISPOSITIF A SEMI-CONDUCTEUR A POMPAGE OPTIQUE EMETTANT UN RAYONNEMENT ET SON PROCEDE DE PRODUCTION

(84) Benannte Vertragsstaaten:
**DE**

(30) Priorität: **05.09.2002   DE 10241192**

(43) Veröffentlichungstag der Anmeldung:
**01.06.2005   Patentblatt 2005/22**

(73) Patentinhaber: **OSRAM Opto Semiconductors GmbH**
**93055 Regensburg (DE)**

(72) Erfinder:
• **KARNUTSCH, Christian**
  **97999 Igersheim (DE)**
• **LINDER, Norbert**
  **93138 Lappersdorf (DE)**
• **LUFT, Johann**
  **93195 Wolfsegg (DE)**

• **LUTGEN, Stephan**
  **93047 Regensburg (DE)**
• **SCHMID, Wolfgang**
  **93180 Deuerling / Hillohe (DE)**

(74) Vertreter: **Epping - Hermann - Fischer Patentanwaltsgesellschaft mbH**
**Ridlerstrasse 55**
**80339 München (DE)**

(56) Entgegenhaltungen:
US-A- 5 748 653      US-A- 5 796 771
US-A1- 2002 001 328      US-A1- 2002 075 935

• **PATENT ABSTRACTS OF JAPAN vol. 1996, no. 01, 31. Januar 1996 (1996-01-31) & JP 07 249824 A (HITACHI LTD), 26. September 1995 (1995-09-26)**

**Beschreibung**

Die Erfindung bezieht sich auf eine optisch gepumpte strahlungsemittierende Halbleitervorrichtung nach dem Oberbegriff des Patenanspruchs 1 sowie ein Verfahren zu deren Herstellung nach dem Oberbegriff der Patentansprüchs 19 oder 25.

Eine optische gepumpte strahlungsemittierende Halbleitervorrichtung ist beispielsweise aus der Druckschrift DE 100 26 734.3 bekannt. Hierin ist eine optisch gepumpte oberflächenemittierende Halbleiterlaservorrichtung mit einer strahlungserzeugenden Quantentopfstruktur und einer Pumpstrahlungsquelle, beispielsweise einem Pumplaser, zum optischen Pumpen der Quantentopfstruktur beschrieben. Die Quantentopfstruktur und die Pumpstrahlungsquelle sind auf einem gemeinsamen Substrat epitaktisch aufgewachsen.

Bei einem Herstellungsverfahren einer solchen Halbleiterlaservorrichtung wird zunächst in einem ersten Epitaxieschritt auf einem Substrat die Quantentopfstruktur aufgewachsen. Nachfolgend wird die Quantentopfstruktur teilweise entfernt, beispielsweise abgeätzt, und in einem zweiten Epitaxieschritt auf die so freigelegten Bereiche die Pumpstrahlungsquelle aufgewachsen.

Im Grenzbereich zwischen der Pumpstrahlungsquelle und der Quantentopfstruktur kann dabei im zweiten Epitaxieschritt ein sogenannter Anwachsbereich entstehen, dessen Kristallstruktur vergleichsweise viele Kristalldefekte aufweist. In diesem Anwachsbereich können daher bei der Einkopplung der Pumpstrahlung in die Quantentopfstruktur optische Verluste auftreten, die die Effizienz der Halbleiterlaservorrichtung verringern. US 5, 748,653 und US 2002/0075935 offenbaren ähnliche Vorrichtungen.

Es ist Aufgabe der vorliegenden Erfindung, eine optisch gepumpte strahlungsemittierende Halbleitervorrichtung mit einer Quantentopfstruktur und einer Pumpstrahlungsquelle, die monolithisch integriert sind, mit einer verbesserten Effizienz zu schaffen. Insbesondere sollen die Verluste bei der Einkopplung der Pumpstrahlung in die Quantentopfstruktur verringert werden. Weiterhin ist es Aufgabe der Erfindung, ein Herstellungsverfahren hierfür anzugeben.

Diese Aufgabe wird durch eine Halbleitervorrichtung gemäß Patentanspruch 1 bzw. ein Herstellungsverfahren gemäß Patentanspruch 19 oder 25 gelöst. Vorteilhafte Weiterbildungen der Erfindung sind Gegenstand der abhängigen Ansprüche.

Erfindungsgemäß ist vorgesehen, eine optische gepumpte strahlungsemittierende Halbleitervorrichtung mit einem Halbleiterkörper, der mindestens eine Pumpstrahlungsquelle und eine oberflächenemittierende Quantentopfstruktur aufweist, zu bilden, wobei die Pumpstrahlungsquelle und die Quantentopfstruktur monolithisch integriert sind und aus unterschiedlichen Halbleiterschichtenfolgen gebildet sind, und die Pumpstrahlungsquelle Pumpstrahlung zum optischen Pumpen der Quantentopfstruktur erzeugt. In dem Halbleiterkörper ist zwischen der Pumpstrahlungsquelle und der Quantentopfstruktur eine Ausnehmung zur Einkopplung der Pumpstrahlung in die Quantentopfstruktur geformt. Die Ausnehmung ist insbesondere so angeordnet, daß bei ihrer Ausbildung der Anwachsbereich zwischen der Quantentopfstruktur und der Pumpstrahlungsquelle entfernt wird. Es hat sich gezeigt, daß die Einkopplungsverluste für die Pumpstrahlung mittels einer solchen definiert ausgebildeten Ausnehmung gegenüber einer Einkopplung durch den oben beschriebenen Anwachsbereich hindurch vorteilhaft verringert werden.

Die Erfindung eignet sich insbesondere für Halbleitervorrichtungen, bei der die Pumpstrahlungsquelle und die oberflächenemittierende Quantentopfstruktur aus unterschiedlichen Halbleiterschichtenfolgen gebildet sind.

Bevorzugt sind diese Halbleiterschichtenfolgen epitaktisch und nacheinander auf einem gemeinsamen Substrat ausgebildet. Dies hat den Vorteil, daß Halbleiterschichtenfolgen für die Pumpstrahlungsquelle und die oberflächenemittierende Quantentopfstruktur unabhängig voneinander an die jeweiligen Anforderungen, beispielsweise unterschiedliche Emissionswellenlängen, angepaßt werden können.

Bei einer vorteilhaften Weiterbildung der Erfindung ist die Ausnehmung in Form eines Grabens ausgebildet, wobei der Graben senkrecht oder schräg zu einer Ausbreitungsrichtung der Pumpstrahlung, vorzugsweise zur Hauptabstrahlungsrichtung der Pumpstrahlungsquelle, verläuft. Eine grabenförmige Ausnehmung ist vergleichsweise platzsparend und kann bei der Herstellung mit geringem technischem Aufwand, beispielsweise als Ätzgraben, ausgeformt werden.

Bevorzugt weist die Ausnehmung eine erste Seitenfläche und eine gegenüberliegende, vorzugsweise parallele zweite Seitenfläche auf, wobei die von der Pumpstrahlungsquelle erzeugte Pumpstrahlung zunächst durch die erste Seitenfläche in die Ausnehmung und nachfolgend durch die gegenüberliegende zweite Seitenfläche in die Quantentopfstruktur eingekoppelt wird. Durch die Entfernung des Anwachsbereichs bei der Ausformung der Ausnehmung mit definierten Seitenflächen werden die Verluste bei der Einkopplung der Pumpstrahlung in die Quantentopfstruktur vorteilhaft reduziert.

Um Reflexionen an den Seitenflächen der Ausnehmung zu vermeiden, ist es weiterhin vorteilhaft, die Ausnehmung mit einem Dielektrikum oder einem Halbleitermaterial zu füllen. Damit wird der Berechungsindexsprung an den Seitenflächen verringert, in der Folge die Reflexion der Pumpstrahlung an den Seitenflächen reduziert, und so die Einkopplung der Pumpstrahlung in die Quantentopfstruktur weiter erhöht. Vorzugsweise ist das Material für die Füllung der Ausnehmung so gewählt, daß sein Berechungsindex möglichst ähnlich oder sogar gleich dem Brechungsindex des angrenzenden Halbleitermaterials, insbesondere im pumpstrahlungsführenden Bereich der Pumpstrahlungsquelle, ist.

Allerdings kann es auch zweckmäßig sein, eine definierte Reflexion an den Seitenflächen der Ausnehmung, vorzugsweise an der der Pumpstrahlungsquelle zugewandten Seitenfläche vorzusehen. Bei einer solchen Ausgestaltung der Erfindung kann die Pumpstrahlungsquelle als Laser ausgeführt sein, wobei die reflektierende Seitenfläche zugleich als Resonatorspiegel dient.

Zur Reduzierung von Reflexionsverlusten an den Seitenflächen sind bei einer bevorzugten Weiterbildung der Erfindung die Seitenflächen so angeordnet, daß sie mit einer Hauptabstrahlungsrichtung der Pumpstrahlungsquelle einen Winkel einschließen, der gleich dem Brewster-Winkel ist. Der Brewster-Winkel $\alpha_B$ ist gegeben durch die Beziehung

$$\tan \alpha_B = n_A / n_P$$

wobei $n_A$ den Brechungsindex des in der Ausnehmung befindlichen Materials - gegebenenfalls auch Luft oder eine anderes geeignetes Gas - und $n_P$ den Brechungsindex des angrenzenden Halbleitermaterials der Pumpstrahlungsquelle, in dem die Pumpstrahlung propagiert, bezeichnet. Durch die Anordnung der Seitenflächen im Brewster-Winkel zur Hauptabstrahlungsrichtung der Pumpstrahlungsquelle werden für diejenigen Pumpstrahlungsanteile, die parallel zur Einfallsebene (bezüglich der Seitenfläche der Ausnehmung) polarisiert sind, die Reflexionsverluste minimiert.

Vorzugsweise ist bei der Erfindung die Pumpstrahlungsquelle als Laser, insbesondere als kantenemittierender Laser oder als Ringlaser ausgebildet. Damit wird eine starke Bündelung der Pumpstrahlung mit genau definierter Propagationsrichtung und eine schmale spektrale Verteilung erreicht. Die Pumpstrahlung kann so optimal zum optischen Pumpen der Quantentopfstruktur ausgelegt und exakt in die Quantentopfstruktur eingestrahlt werden. Weiterhin kann die Quantentopfstruktur auch innerhalb eines Resonators des Pumplasers angeordnet sein.

Die Pumpstrahlung wird bei der Erfindung vorzugsweise in lateraler Richtung in die Quantentopfstruktur eingekoppelt, die Strahlungsemission der Quantentopfstruktur erfolgt im Wesentlichen vertikal, also senkrecht zur Ausbreitungsrichtung der Pumpstrahlung. Weitergehend kann die Halbleitervorrichtung als vertikal emittierender Laser, beispielsweise als VCSEL (Vertical Cavity Surface Emitting Laser) oder als Scheibenlaser ausgeführt sein.

Bei einem erfindungsgemäßen Herstellungsverfahren für eine optisch gepumpte strahlungsemittierende Halbleitervorrichtung wird zunächst ein Substrat zum Aufwachsen des Halbleiterkörpers bereitgestellt und darauf eine Mehrzahl von Halbleiterschichten, die unter anderem die Quantentopfstruktur bilden, epitaktisch aufgewachsen. Nachfolgend werden diese Halbleiterschichten teilweise entfernt und auf den so freigelegten Bereichen die Pumpstrahlungsquelle aufgewachsen, so daß die Pumpstrahlungsquelle an die Quantentopfstruktur lateral angrenzt. Dabei wachsen die Halbleiterschichten der Pumpstrahlungsquelle mit den Halbleiterschichten der Quantentopfstruktur lateral zusammen, so daß zwischen der Pumpstrahlungsquelle und der Quantentopfstruktur ein Anwachsbereich mit vergleichsweise stark gestörter Kristallstruktur entsteht.

Zwischen Pumpstrahlungsquelle und Quantentopfstruktur wird dann eine Ausnehmung zur Einkopplung der Pumpstrahlung in die Quantentopfstruktur gebildet. Dabei wird der Anwachsbereich, der aufgrund einer vergleichsweise hohen Kristalldefektedichte bei der Einkopplung der Pumpstrahlung zu optischen Verlusten beitragen kann, zumindest teilweise entfernt und so die Einkopplungseffizienz verbessert.

Bevorzugt wird die Ausnehmung in den Halbleiterkörper geätzt. Hierfür eignen sich sowohl naßchemische Verfahren als auch trockenchemische Verfahren, wie beispielsweise RIBE Verfahren oder CAIBE. Wie bereits beschrieben ist die Ausbildung der Ausnehmung als Ätzgraben vorteilhaft.

Bei einer anderen Ausführungsform des Verfahrens wird zunächst eine Schichtenfolge für die Pumpstrahlungsquelle auf das Substrat aufgewachsen, in der dann ein Fenster ausgebildet wird. In dem Fenster wird nachfolgend die Mehrzahl von Halbleiterschichten, die unter anderem die Quantentopfstruktur bilden, epitaktisch aufgewachsen.

Zwischen der Schichtenfolge der Pumpstrahlungsquelle und der Quantentopfstruktur entsteht dabei ein Anwachsbereich mit vergleichsweise stark gestörter Kristallstruktur. Die weiteren Schritte zur zumindest teilweisen Beseitigung des Anwachsbereichs erfolgen analog zu denen der oben beschriebenen ersten Ausführungsform des Verfahrens.

Bevorzugt wird bei den Herstellungsverfahren die Ausnehmung mit einem Halbleitermaterial oder einem Dielektrikum gefüllt, um den Brechungsindexsprung zwischen Ausnehmung und angrenzendem Halbleitermaterial und die damit einhergehenden Reflektionsverluste zu reduzieren. Beispielsweise kann die Ausnehmung mit Silikon gefüllt werden.

Ein Vorteil der oben dargelegten Zweischritt-Epitaxie besteht insbesondere darin, dass es damit möglich ist, die oberflächenemittierende Quantentopfstruktur nicht dotiert und elektrisch leitfähig herzustellen. Dotierung würde in der Regel zu höheren Absorptionsverlusten in der oberflächenemittierenden Quantentopfstruktur führen.

Weitere Merkmale, Vorzüge und Zweckmäßigkeiten der Erfindung ergeben sich aus der nachfolgenden Beschreibung von Ausführungsbeispielen der Erfindung in Verbindung mit den Figuren 1 bis 6.

Es zeigen:

Figur 1a und 1b eine schematische Schnittdarstellung und eine Aufsicht auf ein erstes Ausführungsbeispiel einer erfindungsgemäßen Halbleitervorrichtung,

Figur 2 eine schematische Aufsicht auf ein zweites Ausführungsbeispiel einer erfindungsgemäßen Halbleitervorrichtung

Figur 3 eine schematische Schnittdarstellung eines dritten Ausführungsbeispiels einer erfindungsgemäßen Halbleitervorrichtung

Figur 4a bis 4f eine schematische Darstellung eines erfindungsgemäßen Herstellungsverfahrens anhand von sechs Zwischenschritten,

Figur 5 ein erstes Ausführungsbeispiel einer Laseranordnung mit einer erfindungsgemäßen Halbleitervorrichtung und

Figur 6 eine schematische Darstellung eines zweiten Ausführungsbeispiel einer Laseranordnung mit einer erfindungemäßen Halbleitervorrichtung.

Gleiche oder gleichwirkende Elemente sind in den Figuren mit denselben Bezugszeichen versehen.

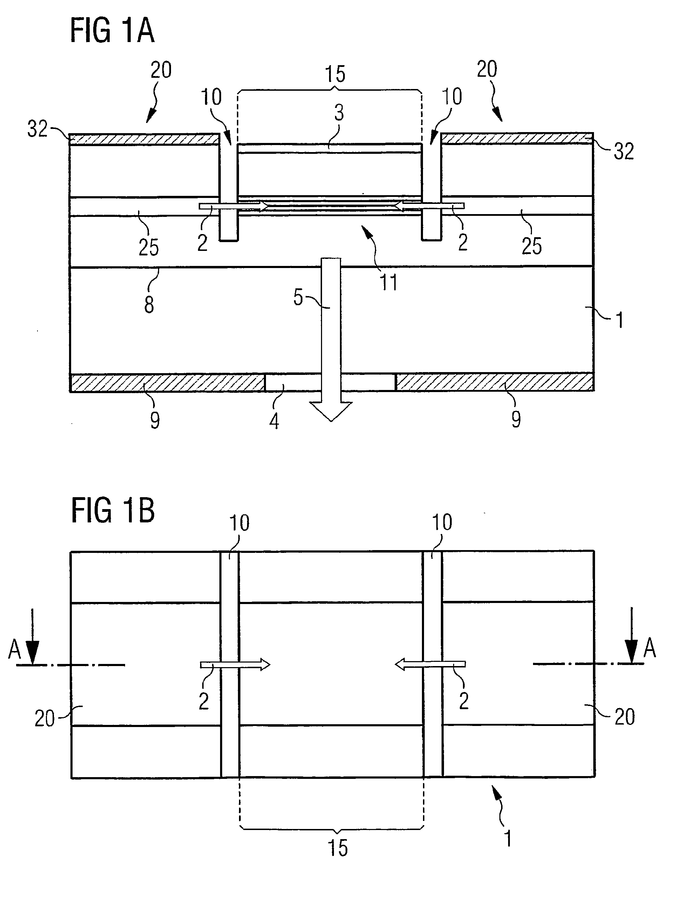

In Figur 1a ist eine optisch gepumpte strahlungsemittierende Halbleitervorrichtung im Schnitt dargestellt, Figur 1b zeigt die zugehörige Aufsicht. Die zur Figur 1a gehörige Schnittebene verläuft längs der Linie A-A in Figur 1 b. Die Halbleitervorrichtung weist einen auf einem Substrat 1 angeordneten Halbleiterkörper auf, der einen oberflächenemittierenden Bereich 15 und zwei Pumpstrahlungsquellen 20 umfaßt. In dem oberflächenemittierenden Bereich 15 ist eine oberflächenemittierende Quantentopfstruktur 11 ausgebildet, die im Betrieb von den Pumpstrahlungsquellen 20 optisch gepumpt wird und Strahlung 5 erzeugt, die senkrecht zur Oberfläche 4 des Substrats 1 bzw. der Grenzfläche 8 zwischen dem Halbleiterkörper und dem Substrat 1 emittiert wird.
Die Pumpstrahlungsquellen 20 sind als kantenemittierende Halbleiterlaser ausgeführt, die in herkömmlicher Weise elektrisch gepumpt werden. Zur elektrischen Versorgung ist auf der Oberseite des Halbleiterkörpers eine p-Kontaktschicht 32 und gegenüberliegend auf dem Substrat eine n-Kontaktschicht 9 aufgebracht. Die kantenemittierenden Halbleiterlaser weisen jeweils eine aktive strahlungsemittierende Schicht 25 auf, die im Betrieb Pumpstrahlung 2 lateral in Richtung des oberflächenemittierenden Bereichs 15 bzw. der Quantentopfstruktur 11 emittiert.
Die Quantentopfstruktur 11 innerhalb des oberflächenemittierenden Bereichs 15 ist in gleicher Höhe über dem Substrat wie die aktiven Schichten 25 der kantenemittierenden Halbleiterlaser angeordnet. Damit wird erreicht, daß die von den Halbleiterlasern erzeugte Pumpstrahlung 2 möglichst vollständig in die Quantentopfstruktur 11 eingekoppelt wird und so die Quantentopfstruktur mit hoher Effizienz optisch gepumpt wird.

Zur Steigerung der Pumpeffizienz ist bei der Erfindung jeweils zwischen den Pumpstrahlungsquellen 20 und dem oberflächenemittierenden Bereich 15 mit der Quantentopfstruktur 11 eine Ausnehmung 10 in Form eines Grabens gebildet.
Herkömmlicherweise wird bei der Herstellung der gezeigten Halbleitervorrichtung, die im Folgenden noch genauer beschrieben wird, eine Mehrzahl von Halbleiterschichten zur Ausbildung der Quantentopfstruktur 11 und der Pumpstrahlungsquellen 20 auf das Substrat 1 aufgebracht. Dabei kann ein sogenannter Anwachsbereich entstehen, in dem die Halbleiterschichten der Pumpstrahlungsquellen 20 mit den Halbleiterschichten der Quantentopfstruktur 11 lateral zusammenwachsen. Da die Kristallstruktur im Anwachsbereich vergleichsweise stark gestört ist, kann in diesem Bereich vermehrt eine Streuung oder Absorption der Pumpstrahlung 2 auftreten. Die gestreute oder absorbierte Pumpstrahlung 2 steht somit zum optischen Pumpen der Quantentopfstruktur 11 nicht zur Verfügung, so daß in der Folge die Pumpeffizienz sinkt.
Bei der Erfindung ist wird durch zumindest teilweise Entfernung des Halbleitermaterial in Anwachsbereichs eine Ausnehmung 10, beispielsweise in der genannten Grabenform, gebildet. Vorteilhafterweise wird dadurch Streuung oder Absorption der Pumpstrahlung in dem Anwachsbereich verringert und in der Folge die Pumpeffizienz erhöht.

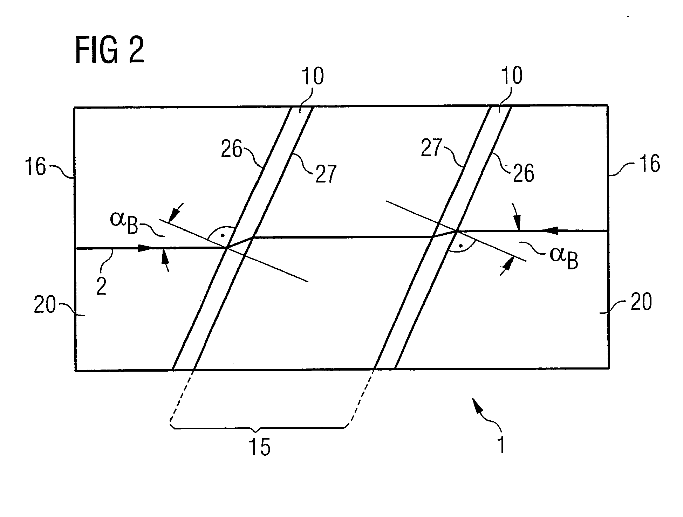

In Figur 2 ist ein zweites Ausführungsbeispiel einer erfindungsgemäßen Halbleitervorrichtung in der Aufsicht dargestellt. Die Halbleitervorrichtung entspricht der in Figur 1b gezeigten Aufsicht mit dem Unterschied, daß die grabenförmigen Ausnehmungen 10 schräg zu einer Ausbreitungsrichtung der Pumpstrahlung 2 verlaufen.
Bei diesem Ausführungsbeispiel ist es besonders vorteilhaft, die Ausnehmung 10 so zu bilden, daß deren Seitenflächen 26 und 27, also die Grenzflächen zwischen Pumpstrahlungsquelle 20 bzw. oberflächenemittierendem Bereich 15 und Ausnehmung 10, zueinander parallel sind und mit einer Hauptabstrahlungsrichtung der Pumpstrahlungsquelle 20 einen Winkel einschließen, der gleich dem Brewster-Winkel $\alpha_B$ ist. Für den Übergang zwischen dem Halbleiterkörper und der Ausnehmung ist der Brewster-Winkel $\alpha_B$ gegeben durch die Beziehung

$$\tan \alpha_B = n_A \; / \; n_P$$

wobei $n_P$ den Brechungsindex des Halbleitermaterials der Pumpstrahlungsquelle 20, insbesondere der pumpstrahlungsführenden Schicht, und $n_A$ den Brechungsindex des in der Ausnehmung 10 befindlichen Materials bezeichnet. Gegebenenfalls kann die Ausnehmung auch mit einem Gas, beispielsweise Luft, gefüllt oder evakuiert sein, wobei dann der Brechungsindex $n_A$ näherungsweise 1,0 beträgt.

Die Anordnung der Seitenflächen 26, 27 der Ausnehmung im Brewster-Winkel zur Hauptabstrahlungsrichtung der Pumpstrahlungsquelle hat den Vorteil, daß Reflexionen der Pumpstrahlung an den Seitenflächen der Ausnehmung reduziert und so die Pumpeffizienz erhöht wird.

Vorzugsweise ist bei diesem Ausführungsbeispiel die Pumpstrahlungsquelle als kantenemittierender Halbleiterlaser ausgeführt, wobei die äußeren Seitenflächen 16 des Halbleiterkörpers die Resonatorspiegel bilden, und der oberflächenemittierende Bereich im Inneren des so gebildeten Laserresonators angeordnet ist.

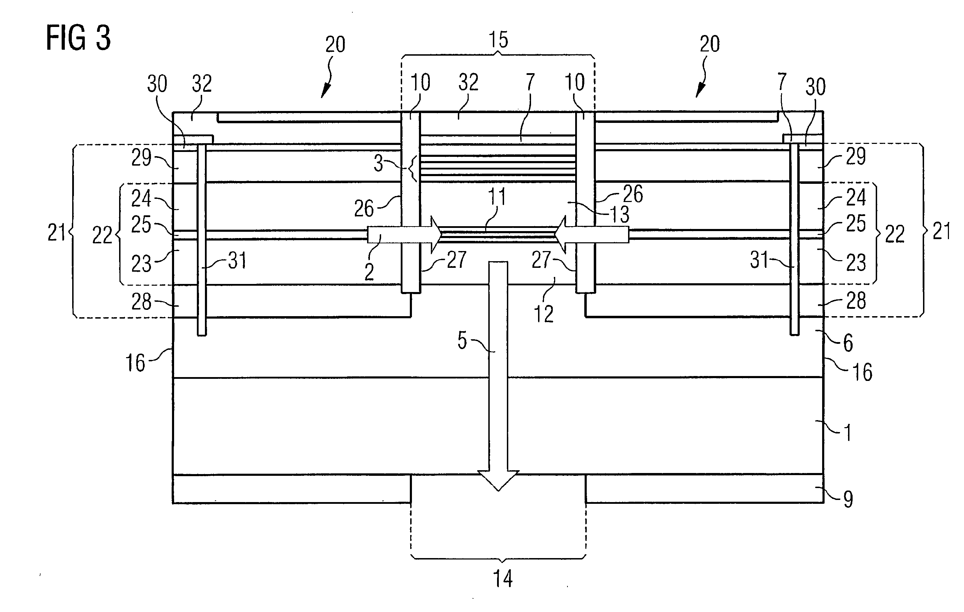

In Figur 3 ist ein drittes Ausführungsbeispiel der Erfindung im Schnitt dargestellt. Die Struktur entspricht dem in Figur 1 gezeigten Ausführungsbeispiel.

Die dargestellte Halbleitervorrichtung weist ein Substrat 1 auf, auf dem eine Buffer-Schicht 6 aufgebracht ist. Als Material für das Substrat kann beispielweise GaAs, für die Bufferschicht undotiertes GaAs verwendet werden.

Auf der Bufferschicht 6 sind nacheinander in dem oberflächenemittierenden Bereich 15 eine erste Confinement-Schicht 12, eine Quantentopfstruktur 11 und eine zweite Confinement-Schicht 13 angeordnet. Die Confinement-Schichten 12, 13 können zum Beispiel undotiertes GaAs enthalten. Die Quantentopfstruktur 11 umfaßt bevorzugt drei oder mehr Quantentöpfe mit einer Dicke entsprechend einer ersten Emissionswellenlänge für die von der Quantentopfstruktur zu erzeugenden Strahlung 5, die durch Barriereschichten voneinander beabstandet sind. Die Quantentopfstuktur ist beispielsweise aus InGaAs mit einer Dicke entsprechend einer Emissionswellenlänge von 1030 nm für die von der Quantentopfstruktur zu erzeugenden Strahlung 5 und die Barriereschichten sind beispielsweise aus GaAs.

Der zweiten Confinement-Schicht 13 nachgeordnet ist ein Bragg-Spiegel 3. Dieser kann zum Beispiel durch jeweils 28 bis 30 abwechselnde Schichten (Perioden) aus $Ga_{0.1}Al_{0.9}As$ bzw. $Ga_{0.9}Al_{0.1}As$ gebildet sein.

Neben dem oberflächenemittierenden Bereich 15 sind zwei Pumpstrahlungsquellen 20, jeweils in Form einer kantenemittierenden Halbleiterstruktur 21, angeordnet. Die von den kantenemittierenden Halbleiterstrukturen 21 erzeugte Pumpstrahlung 2 wird in lateraler Richtung in die Quantentopfstruktur 11 eingekoppelt.

Bevorzugt sind die kantenemittierenden Halbleiterstrukturen 21 als LOC-Laserstrukturen (Large Optical Cavity) mit jeweils einer Einfachquantentopfstruktur (SQW - Single Quantum Well) ausgebildet. Für die Pumpstrahlung 2 ist eine Emissionswellenlänge geeignet, die kleiner ist als die erste Emissionswellenlänge für die von der Quantentopfstruktur zu erzeugenden Strahlung 5. Bei den bisher genannten Daten ist für die Pumpstrahlung eine Emissionwellenlänge von etwa 1000 nm geeignet.

Die kantenemittierenden Halbleiterstrukturen 21 setzen sich vom Subtrat 1 aus gesehen jeweils zusammen aus einer ersten Mantelschicht 28, beispielsweise aus $n\text{-}Ga_{0.35}Al_{0.65}As$, die auf die Buffer-Schicht 6 aufgebracht ist, einer ersten Wellenleiterschicht 23, beispielsweise aus $n\text{-}Ga_{0.90}Al_{0.10}As$, einer aktiven Schicht, beispielsweise aus undotiertem InGaAs in Form einer $SQW\text{-}Ga_{0.35}Al_{0.65}As$-Schicht, einer zweiten Wellenleiterschicht 24, beispielsweise aus $p\text{-}Ga_{0.90}Al_{0.10}As$, und einer zweiten Mantelschicht 29, beispielsweise aus $p\text{-}Ga_{0.35}Al_{0.65}As$. Abschließend ist auf der zweiten Mantelschicht 29 eine Deckschicht 30, zum Beispiel eine $p^+$-dotierte GaAs-Schicht und darauf die p-Kontaktschicht 32 ausgebildet.

Die LOC-Struktur 22 wird von den beiden Wellenleiterschichten 23, 24 und der dazwischenliegenden aktiven Schicht 25 gebildet. Der Abstand dieser LOC-Struktur zum Substrat ist so bemessen, daß die strahlungsführende Schicht 25 in gleicher Höhe wie die Quantentopfstruktur 11 über dem Substrat angeordnet ist und so die erzeugte Pumpstrahlung 2 in lateraler Richtung möglichst vollständig in die Quantentopfstruktur eingestahlt wird.

Zwischen den Pumpstrahlungsquellen 20 und dem oberflächenemittieren Bereich 15 ist der Anwachsbereich entfernt worden, so daß jeweils eine Ausnehmung 10

zwischen den Pumpstrahlungsquellen 20 und dem oberflächenemittieren Bereich 15 gebildet ist. Bevorzugt ist die Ausnehmung mit einem für die Pumpstrahlung durchlässigen Material gefüllt. Besonders bevorzugt wird zur Füllung ein Silikon oder ein Halbleitermaterial verwendet. Weitergehend ist es vorteilhaft, wenn dieses Material einen Brechungsindex aufweist, der etwa dem Brechungsindex der angrenzenden Pumpstrahlungsquelle und/oder der Quantentopfstruktur oder dem geometrischen Mittel dieser beiden Berechungsindices entspricht.

Maßgeblich für die Brechungsindexanpassung sind bei den Pumpstrahlungsquellen 20 die Brechungsindices der strahlungsführenden Schichten. Eine derartige Brechungsindexanpassung reduziert vorteilhafterweise Reflexionsverluste an den Seitenflächen der Ausnehmung 10.

Vorzugsweise sind die genannten Halbleiterschichten epitaktisch, zum Beispiel mittels metallorganischer Dampfphasenepitaxie (MOVPE), auf dem Substrat 1 aufgewachsen.

In der Nähe der jeweiligen äußeren Seitenflächen 16 der Pumpstrahlungsquellen sind senkrecht zu den Schichten der kantenemittierenden Halbleiterstrukturen verlaufende Spiegelschichten 31 ausgebildet, die als Endspiegel für die kantenemittierenden LOC-Laserstrukturen 22 dienen. Diese Spiegelschichten erstrecken sich ausgehend von der Deckschicht 30 bis mindestens in die erste Mantelschicht 28, vorzugsweise wie dargestellt in die Buffer-Schicht 6. Derartige Spiegelschichten 31 können nach dem Aufwachsen der Halbleiterschichten für die kantenemittierende Halbleiterstruktur dadurch hergestellt werden, daß zunächst mittels eines Ätzverfahrens, beispielsweise reaktives Ionenätzen, Ätzgräben ausgebildet werden, die nachfolgend mit einem geeigneten reflektierenden Material gefüllt werden.

Alternativ können als Endspiegel auch die äußeren Seitenflächen 16 der Pumpstrahlungsquellen 20, die in diesem Fall vorzugsweise durch Spalten des entsprechenden Wafers ausgebildet werden, dienen.

Die kantenemittierenden Laserstrukturen können auch in einem gemeinsamen, von den beiden Spiegelschichten 31 bzw. Seitenflächen 16 begrenzten Resonator angeordnet sein, so daß sich auch die Quantentopfstruktur innerhalb dieses Resonators befindet. Alternativ können die von der Quantentopfstruktur 11 aus gesehen außenliegenden Seitenflächen 16 der Ausnehmung 10 zusammen mit der zugehörigen Spiegelfläche 31 bzw. Seitenfläche 27 jeweils einen Resonator für die kantenemittierenden Halbleiterlaser bilden, so daß die Quantentopfstruktur 11 zwischen diesen beiden Resonatoren angeordnet ist. Eine weitere Alternative besteht darin, die Pumpstrahlungsquelle als Ringlaser auszubilden und die Quantentopfstruktur innerhalb des Ringresonators anzuordnen.

Auf der freien Oberfläche der Deckschicht 30 und des Bragg-Spiegels 3 ist eine elektrisch isolierende Maskenschicht 7, beispielsweise eine Siliziumnitrid-, eine Siliziumoxid- oder eine Aluminiumoxidschicht, angeordnet, die die Strominjektionspfade von der p-Kontaktschicht 32, beispielsweise eine Kontaktmetallisierung, in die Pumpstrahlungsquellen 20 festlegt. Insbesondere wird dadurch erreicht, daß der Pumpstrom nur in die Pumpstrahlungsquellen 20 injiziert und so ein unerwünschtes elektrisches Pumpen der Quantentopfstruktur 11 vermieden wird.

Auf der der Quantentopfstruktur 11 bzw. den Pumpstrahlungsquellen 20 gegenüberliegenden Oberfläche 4 des Substrats 1 ist korrespondierend zur p-Kontaktschicht 32 eine n-Kontaktschicht 9, beispielsweise eine Kontaktmetallisierung, aufgebracht, die in dem oberflächenemitterenden Bereich 15 ausgespart ist. Diese Aussparung bildet ein Austrittsfenster 14 für die von der Quantentopfstruktur 11 erzeugte Strahlung 5. Vorzugsweise ist die Oberfläche 4 des Substrats innerhalb des Austrittsfensters 14 entspiegelt, um Rückreflexionen der von der Quantentopfstruktur 11 emittierten Strahlung 5 zu verringern.

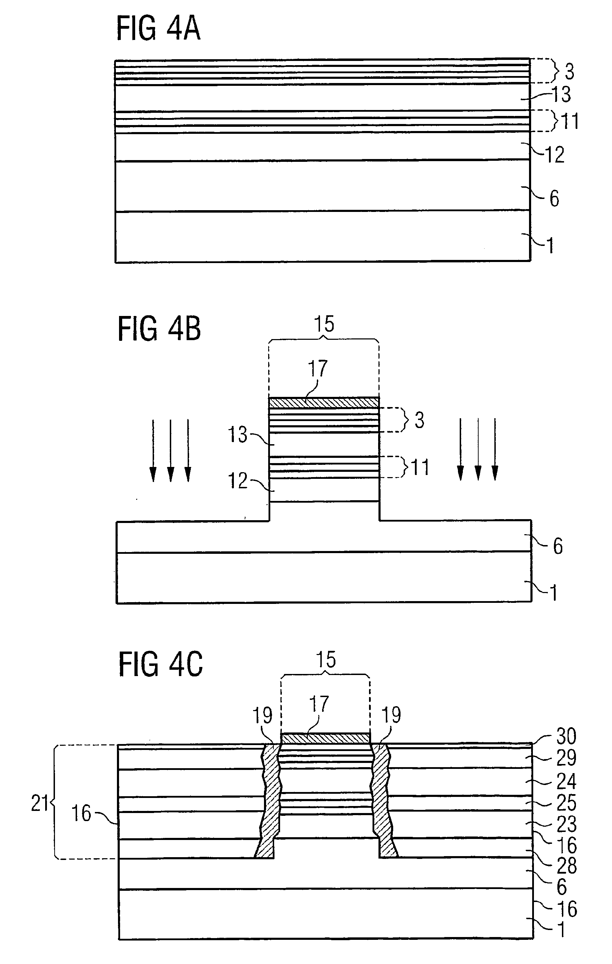

In den Figuren 4a bis 4f ist in sechs Zwischenschritten schematisch ein Herstellungsverfahren für eine erfindungsgemäße Halbleitervorrichtung gezeigt. Die herzustellende Halbleitervorrichtung entspricht im Wesentlichen Figur 3.

In einem ersten Schritt, Figur 4a, werden, beispielsweise mittels eines MOVPE-Verfahrens, auf das Substrat 1 nacheinander die Buffer-Schicht 6, die erste Confinement-Schicht 12, die Quantentopfstruktur 11, die zweite Confinement-Schicht 13 und die Schichten für den Bragg-Spiegel 3 aufgewachsen.

Nachfolgend wird in einem zweiten Schritt, Figur 4b, in dem als oberflächenemittieren Bereich 15 vorgesehenen Bereich eine Ätzmaske 17, zum Beispiel eine Siliziumnitridmaske, aufgebracht. Mittels eines Ätzverfahrens werden dann die Schichten für den Bragg-Spiegel 3, die Confinement-Schichten 12 und 13, die Quantentopfstruktur 11 und ein Teil der Buffer-Schicht 6 außerhalb des oberflächenemittierenden, nicht von der Ätzmaske 17 bedecken Bereichs abgetragen. Hierfür ist beispielsweise ein Trockenätzverfahren geeignet.

Auf die so freigelegten Bereiche der Buffer-Schicht 6 werden in einem dritten Schritt, Figur 4c, zur Ausbildung der Pumpstrahlungsquellen 20 in Form der beschriebenen kantenemittierenden Halbleiterlaser die erste Mantelschicht 28, die erste Wellenleiterschicht 23, die aktive Schicht 25, die zweite Wellenleiterschicht 24, die zweite Mantelschicht 29 und die Deckschicht 30 nacheinander, beispielsweise wiederum mittels eines MOVPE-Verfahrens, aufgebracht.

Dabei wachsen diese Schichten sowohl in vertikaler als auch in geringerem Grad in lateraler Richtung auf. Dies führt dazu, daß die Halbleiterschichten der Pumpstrahlungsquellen 20 mit den bereits im ersten Schritt aufgebrachten Schichten am Rand des oberflächenemittierenden Bereichs 15 zusammenwachsen. Zwischen dem oberflächenemittieren Bereich 15 und den Pumpstrahlungsquellen 20 entsteht so jeweils der Anwachsbereich 19, der wie bereits beschrieben eine vergleichsweise stark gestörte Kristallstruktur aufweist und die Einkoppeleffizienz der Pumpstrahlung beeinträchtigen kann.

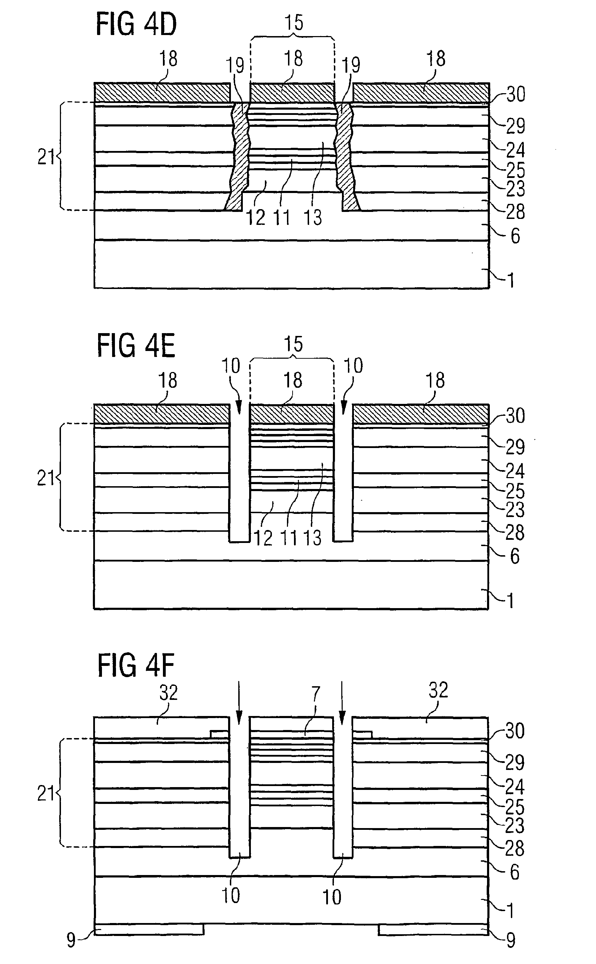

Im Unterschied zu dem in Figur 3 dargestellten Ausführungsbeispiel werden die Endspiegel der kantenemittierenden Halbleiterlaser 21 durch die die äußeren Seitenflächen 16 des Halbleiterkörpers gebildet. Es sei an dieser Stelle angemerkt, daß der Übersichtlichkeit halber in Figur 4 nur die Herstellung einer einzigen Halbleitervorrichtung dargestellt ist. In der Regel wird in eine Mehrzahl derartiger Halbleitervorrichtungen gleichzeitig im Waferverbund hergestellt, die nach Schritt 4c noch lateral verbunden sind bzw. keine Seitenflächen 16 aufweisen. Die Seitenflächen 16 werden vielmehr bei der Zerteilung des Waferverbunds in einem späteren Schritt des Herstellungsverfahrens durch Spalten hergestellt.

Im einem vierten Schritt, Figur 4d, wird auf die Deckschicht 30 eine Ätzmaske 18, beispielsweise eine photolithographisch hergestellte Lackmaske, aufgebracht, die die Deckschicht 30 über den Pumpstrahlungsquellen 20 und dem oberflächenemittierenden Bereich 15 bedeckt und so die darunterliegenden Halbleiterschichten schützt. Über den Anwachsbereichen 19 ist die Ätzmaske 18 ausgespart.

Mittels eines Ätzverfahrens werden in einem nachfolgenden fünften Schritt, Figur 4e, die Anwachsbereiche 19 entfernt. Dabei wird jeweils zwischen einer Pumpstrahlungsquelle 20 und dem oberflächenemittierenden Bereich 15, insbesondere der Quantentopfstruktur 11 eine Ausnehmung 10 in Form eines Ätzgrabens gebildet. Als Ätzverfahren eignet sich bei diesem Schritt ein naßchemisches Verfahren oder ein trockenchemisches Verfahren wie beispielsweise RIBE oder CAIBE.

Nachfolgend kann der Ätzgraben mit einem für die Pumpstrahlung durchlässigen Material, beispielsweise einem Silikon, gefüllt werden. Dazu wird das Silikon aufgeschleudert, photolithographisch strukturiert und dann ausgehärtet.

Abschließend wird in einem sechsten Schritt, Figur 4f, die Ätzmaske 18 entfernt und auf die Deckschicht 30 und den Bragg-Spiegel 3 die elektrisch isolierende Maskenschicht 7 und darauf die p-Kontaktschicht 32 sowie auf der abgewandten Seite des Substrats 1 die Kontaktschicht 9 aufgebracht.

Bei einem zu dem in Verbindung mit den Figuren 4a bis 4f beschriebenen alternativen Verfahrensablauf wird zunächst eine Schichtenfolge für den kantenemittierenden Halbleiterlaser 21, der die Pumpstrahlungsquelle darstellt, auf das Substrat aufgewachsen, in der dann ein Fenster beispielsweise mittels Maskieren und Ätzen ausgebildet wird. In dem Fenster wird nachfolgend die Mehrzahl von Halbleiterschichten für den oberflächenemittierenden Bereich 15 epitaktisch aufgewachsen, die unter anderem die Quantentopfstruktur enthalten.

Zwischen der Schichtenfolge für den kantenemittierenden Halbleiterlaser, also der Pumpstrahlungsquelle und den Halbleiterschichten für den oberflächenemittierenden Bereich 15 entsteht ein Anwachsbereich mit vergleichsweise stark gestörter Kristallstruktur.

Die weiteren Schritte erfolgen bei diesem Verfahrensablauf analog zu den in Verbindung mit den Figuren 4d bis 4f erläuterten Schritte.

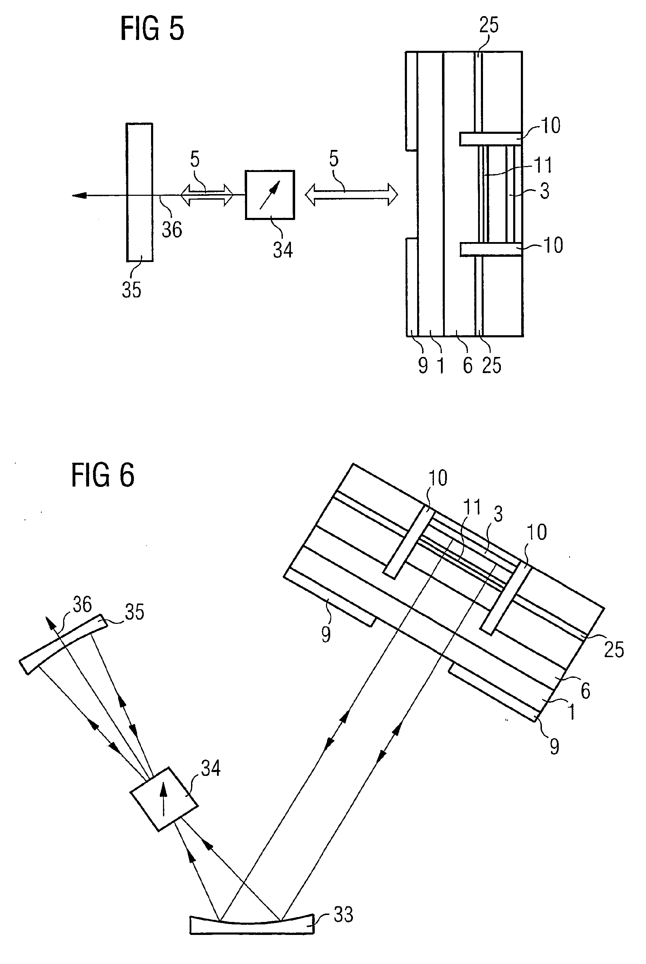

Figur 5 zeigt schematisch ein Ausführungsbeispiel einer Laseranordnung mit einer erfindungsgemäßen Halbleitervorrichtung.

Die Halbleitervorrichtung entspricht beispielsweise einem der in Figur 1 bis 3 gezeigten Ausführungsbeispiele. Dem Substrat 1 der Halbleitervorrichtung gegenüberliegend ist ein externer Spiegel 35 angeordnet, der zusammen mit dem Bragg-Spiegel 3 der Halbleitervorrichtung den Laserresonator der Laseranordnung darstellt. Der Bragg-Spiegel 3 bildet dabei den Endspiegel, der externe Spiegel 35 den Auskoppelspiegel des Resonators.

Der Auskoppelspiegel 35 ist vorzugsweise als teildurchlässiger, dielektrischer Spiegel ausgeführt. Auch die Verwendung eines teildurchlässigen Metallspiegels ist möglich.

Den laseraktiven Bereich der Laseranordnung stellt die optisch gepumpte Quantentopfstruktur 11 der Halbleitervorrichtung dar, in der die Laserstrahlung mittels des optischen Pumpprozesses generiert und verstärkt wird. Bevorzugt ist bei der Laseranordnung ein nichtlineares optisches Element 34, insbesondere ein nichtlinearer optischer Kristall, innerhalb des Laserresonators angeordnet.

Das nichtlineare optische Element 34 dient zur Frequenzkonversion der Laserstrahlung. Hierbei wird durch einen nichtlinearen optischen Prozeß, wie beispielsweise Summenfrequenzerzeugung, Erzeugung der zweiten, dritten oder einer höheren harmonischen oder Differenzfrequenzerzeugung aus der Laserstrahlung elektromagnetischer Strahlung 36 einer anderen Wellenlänge erzeugt. Insbesondere kann so durch Erzeugung von Summenfrequenz oder einer Harmonischen aus der Laserstrahlung, die bei den genannten Halbleiterlasern bzw. Quantentopfstrukturen in der Regel im roten oder infraroten Bereich liegt, kurzwelligeres sichtbares Licht erzeugt werden. Je nach Wellenlänge der Laserstrahlung und der zu erzeugenden Strahlung sind als nichtlineare Medien beispielsweise KTP, KDP, BBO, KNB, LiNbO PPLN oder LBO geeignet.

Bevorzugt ist bei dieser Ausführungsform der Auskoppelspiegel 35 als dichroitischer Spiegel gebildet, der für die von dem nichtlinearem optischen Element 34 generierte Strahlung weitgehend durchlässig und für die Laserstrahlung weitgehend reflektierend ist. Hierfür sind insbesondere dielektrische Auskoppelspiegel geeignet, mit denen typischerweise für die Laserstrahlung ein Reflexionsgrad von mehr als 90 % und zur Auskopplung der mittels des nichtlinearen optischen Elements 34 erzeugten Strahlung ein Reflexionsgrad von unter 10% erreicht werden kann.

In Figur 6 ist ein weiteres Ausführungsbeispiel einer Laseranordnung mit einer erfindungsgemäßen Halbleitervorrichtung gezeigt. Im Unterschied zu dem in Figur 5 gezeigten Ausführungsbeispiel ist der Laserresonator als gefalteter Resonator ausgeführt. Dazu ist in den Strahlengang ein weiterer Spiegel 33 eingefügt, so daß die Resonatorachse abgewinkelt ist. Der weitere Spiegel 33 und der Auskoppelspiegel 35 sind konkav gewölbt, so daß zwischen diesen Spiegeln ein Fokalbereich entsteht, in dem das nichtlineare optische Element 34 angeordnet ist. Durch diese Fokussierung wird die Intensität der von der Quantentopfstruktur 11 generieren Laserstrahlung im Bereich des nichtlinearen optischen Elements 34 und in der Folge die nichtlineare Konversion erhöht.

Die Erläuterung der Erfindung anhand der Ausführungsbeispiele und Figuren ist nicht als Beschränkung der Erfindung zu verstehen. Insbesondere ist es nicht zwingend erforderlich, genau zwei Pumpstrahlungsquellen bei der Erfindung vorzusehen. Die Halbleitervorrichtung kann auch eine einzige Pumpstrahlungsquelle oder mehr als zwei, beispielsweise sternförmig um die Quantentopfstruktur angeordnete Pumpstrahlungsquellen aufweisen.

Allgemein umfaßt die Erfindung auch jede Kombination der im Rahmen der Ausführungsbeispiele und der sonstigen Beschreibung genannten Merkmale, auch wenn diese Kombination nicht Gegenstand eines Patentanspruchs ist.

**Patentansprüche**

**1.** Optisch gepumpte strahlungsemittierende Halbleitervorrichtung mit einem Halbleiterkörper, der mindestens eine Pumpstrahlungsquelle (20) und eine oberflächenemittierende Quantentopfstruktur (11) aufweist, wobei die Pumpstrahlungsquelle (20) und die Quantentopfstruktur (11) monolithisch integriert ausgebildet sind, und die Pumpstrahlungsquelle (20) Pumpstrahlung (2) zum optischen Pumpen der Quantentopfstruktur (11) erzeugt, wobei die Pumpstrahlungsquelle (20) und die oberflächenemittierende Quantentopfstruktur (11) aus unterschiedlichen Halbleiterschichtenfolgen gebildet sind, **dadurch gekennzeichnet, daß** in dem Halbleiterkörper zwischen der Pumpstrahlungsquelle (20) und der Quantentopfstruktur (11) eine Ausnehmung (10) zur Einkopplung der Pumpstrahlung (2) in die Quantentopfstruktur (11) gebildet ist.

2. Halbleitervorrichtung nach Anspruch 1,
**dadurch gekennzeichnet, daß**
die Ausnehmung (10) grabenförmig gebildet ist und schräg oder senkrecht zu einer Ausbreitungsrichtung der Pumpstrahlung (2) verläuft.

3. Halbleitervorrichtung nach Anspruch 1 oder 2,
**dadurch gekennzeichnet, daß**
die Ausnehmung (10) eine erste der Pumpstrahlungsquelle (20) zugewandte Seitenfläche (26) und eine gegenüberliegende, der Quantentopfstruktur (11) zugewandte zweite Seitenfläche (27) aufweist, wobei die Pumpstrahlung (2) durch die erste Seitenfläche (26) in die Ausnehmung (10) und nachfolgend durch die zweite Seitenfläche (27) in die Quantentopfstruktur (11) eintritt.

4. Halbleitervorrichtung nach Anspruch 3,
**dadurch gekennzeichnet, daß**
die zweite Seitenfläche (27) parallel zur ersten Seitenfläche (26) ist.

5. Halbleitervorrichtung nach Anspruch 3 oder 4,
**dadurch gekennzeichnet, daß**
die erste und/oder die zweite Seitenfläche (26,27) mit einer Ausbreitungsrichtung der Pumpstrahlung (2), insbesondere mit einer Hauptabstrahlungsrichtung der Pumpstrahlungsquelle (20), einen Winkel einschließt, der gleich dem Brewster-Winkel ist.

6. Halbleitervorrichtung nach einem der Ansprüche 1 bis 5,
**dadurch gekennzeichnet, daß**
die Ausnehmung (10) mit einem Dielektrikum oder einem Halbleitermaterial gefüllt ist.

7. Halbleitervorrichtung nach Anspruch 6,
**dadurch gekennzeichnet, daß**
die Ausnehmung (10) mit einem Material gefüllt ist, das einen Brechungsindex aufweist, der im Wesentlichen gleich dem Brechungsindex der Pumpstrahlungsquelle (2), dem Brechungsindex der Quantentopfstruktur (11) oder dem geometrischen Mittel der beiden letztgenannten Brechungsindices ist.

8. Halbleitervorrichtung nach einem der Ansprüche 1 bis 7,
**dadurch gekennzeichnet, daß**
die Halbleitervorrichtung einen Vertikalemitter mit einem strahlungserzeugenden Bereich umfaßt, der von der Quantentopfstruktur (11) gebildet wird.

9. Halbleitervorrichtung nach Anspruch 8,
**dadurch gekennzeichnet, daß**
der Vertikalemitter ein vertikal emittierender Laser, insbesondere eine VCSEL oder ein Scheibenlaser, ist.

10. Halbleitervorrichtung nach einem der Ansprüche 1 bis 9,

**dadurch gekennzeichnet, daß**
die Pumpstrahlungsquelle (20) ein Pumplaser ist.

11. Halbleitervorrichtung nach Anspruch 10,
**dadurch gekennzeichnet, daß**
der Pumplaser ein kantenemittierender Laser ist.

12. Halbleitervorrichtung nach Anspruch 10 oder 11,
**dadurch gekennzeichnet, daß**
der Pumplaser ein Ringlaser ist.

13. Halbleitervorrichtung nach einem der Ansprüche 10 bis 12,
**dadurch gekennzeichnet, daß**
der Pumplaser einen Resonator aufweist, und die Quantentopfstruktur (11) innerhalb des Resonators angeordnet ist.

14. Halbleitervorrichtung nach einem der Ansprüche 1 bis 13,
**dadurch gekennzeichnet, daß**
die Pumpstrahlung (2) in lateraler Richtung in die Quantentopfstruktur (11) eingekoppelt wird.

15. Halbleitervorrichtung nach einem der Ansprüche 1 bis 14,

**dadurch gekennzeichnet, daß**
die Pumpstrahlungsquelle (20) und die oberflächenemittierende Quantentopfstruktur (11) epitaktisch und nacheinander gebildet sind.

16. Halbleitervorrichtung nach einem der Ansprüche 1 bis 15,
**dadurch gekennzeichnet, daß**
die Ausnehmung (10) in einem Anwachsbereich zwischen der Pumpstrahlungsquelle (20) und der oberflächenemittierenden Quantentopfstruktur (11) angeordnet ist.

17. Halbleitervorrichtung nach Anspruch 16,
**dadurch gekennzeichnet, daß**
die Ausnehmung (10) durch zumindest teilweises Entfernen des Anwachsbereichs (19) ausgebildet ist.

18. Halbleitervorrichtung nach einem der Ansprüche 1 bis 17,
**dadurch gekennzeichnet, daß**
die Pumpstrahlungsquelle (20) mindestens eine Wellenleiterschicht (23,24) aufweist.

19. Verfahren zur Herstellung einer optisch gepumpten Halbleitervorrichtung mit einem Halbleiterkörper, der eine oberflächenemittierende Quantentopfstruktur (11) und mindestens eine Pumpstrahlungsquelle (20), die Pumpstrahlung (2) zum optischen Pumpen der Quantentopfstruktur (11) erzeugt, aufweist, wobei die Pumpstrahlungsquelle (2) und die Quantentopfstruktur (11) monolithisch integriert sind,
mit den Schritten:

a) Bereitstellen eines Substrates (1),
b) epitaktisches Aufwachsen einer Mehrzahl von Halbleiterschichten auf das Substrat (1), die die Quantentopfstruktur (11) enthalten,
c) teilweises Abtragen der Halbleiterschichten und
d) epitaktisches Aufwachsen der Pumpstrahlungsquelle (20) in dem durch das Abtragen in Schritt c) freigelegten Bereich, so daß die Pumpstrahlungsquelle (20) an die Quantentopfstruktur (11) grenzt,

**dadurch gekennzeichnet, daß**
zwischen der Pumpstrahlungsquelle (20) und der Quantentopfstruktur (11) eine Ausnehmung (10) zur Einkopplung der Pumpstrahlung (2) in die Quantentopfstruktur (11) gebildet wird.

20. Verfahren nach Anspruch 19,
**dadurch gekennzeichnet, daß**
in Schritt d) Halbleiterschichten zur Bildung der Pumpstrahlungsquelle (20) aufgewachsen werden, die in lateraler Richtung in einem Anwachsbereich (19) zumindest teilweise mit der Quantentopfstruktur (11) zusammenwachsen, und die Ausnehmung (10) durch zumindest teilweises Entfernen des Anwachsbereichs (19) ausgebildet wird.

21. Verfahren nach Anspruch 19 oder 20,
**dadurch gekennzeichnet, daß**
die Ausnehmung (10) durch Ätzen, insbesondere naßchemisches oder trockenchemisches Ätzen, gebildet wird.

22. Verfahren nach einem der Ansprüche 19 bis 21,

**dadurch gekennzeichnet, daß**
die Ausnehmung (10) grabenförmig, insbesondere als Ätzgraben, ausgebildet wird.

23. Verfahren nach einem der Ansprüche 19 bis 22,
**dadurch gekennzeichnet, daß**
die Ausnehmung (10) mit einem für die Pumpstrahlung durchlässigen Material gefüllt wird.

24. Verfahren nach Anspruch 23,
**dadurch gekennzeichnet, daß**
die Ausnehmung (10) mit Silikon oder einem Halbleitermaterial gefüllt wird.

25. Verfahren zur Herstellung einer optisch gepumpten Halbleitervorrichtung mit einem Halbleiterkörper, der eine oberflächenemittierende Quantentopfstruktur (11) und mindestens eine Pumpstrahlungsquelle (20), die Pumpstrahlung (2) zum optischen Pumpen der Quantentopfstruktur (11) erzeugt, aufweist, wobei die Pumpstrahlungsquelle (2) und die Quantentopfstruktur (11) monolithisch integriert sind,
mit den Schritten:

a) Bereitstellen eines Substrates (1),
b) epitaktisches Aufwachsen einer Mehrzahl von Halbleiterschichten auf das Substrat (1), die die Pumpstrahlungsquelle (20) enthalten,
c) Ausbilden eines Fensters in der Mehrzahl von Halbleiterschichten für die Quantentopfstruktur (11) und
d) epitaktisches Aufwachsen der Quantentopfstruktur (11) in dem Fenster, so daß die Pumpstrahlungsquelle (20) an die Quantentopfstruktur (11) grenzt,

**dadurch gekennzeichnet, daß** zwischen der Pumpstrahlungsquelle (20) und der Quantentopfstruktur (11) eine Ausnehmung (10) zur Einkopplung der Pumpstrahlung (2) in die Quantentopfstruktur (11) gebildet wird.

26. Verfahren nach Anspruch 25,
**dadurch gekennzeichnet, daß**
in Schritt d) Halbleiterschichten zur Bildung der Quantentopfstruktur (11) aufgewachsen werden, die in lateraler Richtung in einem Anwachsbereich zumindest teilweise mit der Schichtenfolge der Pumpstrahlungsquelle (20) zusammenwachsen, und die Ausnehmung (10) durch zumindest teilweises Entfernen des Anwachsbereichs (19) ausgebildet wird.

27. Verfahren nach Anspruch 25 oder 26,
**dadurch gekennzeichnet, daß**
die Ausnehmung (10) durch Ätzen, insbesondere naßchemisches oder trockenchemisches Ätzen, gebildet wird.

28. Verfahren nach einem der Ansprüche 25 bis 27, **dadurch gekennzeichnet, daß**
die Ausnehmung (10) grabenförmig, insbesondere als Ätzgraben, ausgebildet wird.

29. Verfahren nach einem der Ansprüche 25 bis 28, **dadurch gekennzeichnet, daß**
die Ausnehmung (10) mit einem für die Pumpstrahlung durchlässigen Material gefüllt wird.

30. Verfahren nach Anspruch 29, **dadurch gekennzeichnet, daß**
die Ausnehmung (10) mit Silikon oder einem Halbleitermaterial gefüllt wird.

**Claims**

1. Optically pumped radiation-emitting semiconductor device having a semiconductor body which comprises at least one pump radiation source (20) and a surface-emitting quantum well structure (11), the pump radiation source (20) and the quantum well structure (11) being in monolithically integrated form, and the pump radiation source (20) generating pump radiation (2) for optically pumping the quantum well structure (11), wherein the pump radiation source (20) and the surface-emitting quantum well structure (11) are formed from different semiconductor layer sequences, **characterized in that** a recess (10) for introducing the pump radiation (2) into the quantum well structure (11) is formed in the semiconductor body between the pump radiation source (20) and the quantum well structure (11).

2. Semiconductor device according to Claim 1, **characterized in that** the recess (10) is in trench form and runs obliquely or perpendicular with respect to a direction of propagation of the pump radiation (2).

3. Semiconductor device according to Claim 1 or 2, **characterized in that** the recess (10) has a first side face (26) facing the pump radiation source (20) and an opposite, second side face (27) facing the quantum well structure (11), the pump radiation (2) entering the recess (10) through the first side face (26) and then entering the quantum well structure (11) through the second side face (27).

4. Semiconductor device according to Claim 3, **characterized in that** the second side face (27) is parallel to the first side face (26).

5. Semiconductor device according to Claim 3 or 4, **characterized in that** the first and/or the second side face (26, 27) includes an angle equal to the Brewster angle with a direction of propagation of the pump radiation (2), in particular with a main direction of emission of the pump radiation source (20).

6. Semiconductor device according to one of Claims 1 to 5, **characterized in that** the recess (10) is filled with a dielectric or a semiconductor material.

7. Semiconductor device according to Claim 6, **characterized in that** the recess (10) is filled with a material which has a refractive index substantially equal to the refractive index of the pump radiation source (2), the refractive index of the quantum well structure (11) or the geometric mean of the latter two refractive indices.

8. Semiconductor device according to one of Claims 1 to 7, **characterized in that** the semiconductor device comprises a vertical emitter with a radiation-generating region formed by the quantum well structure (11).

9. Semiconductor device according to Claim 8, **characterized in that** the vertical emitter is a vertically emitting laser, in particular a VCSEL or a disc laser.

10. Semiconductor device according to one of Claims 1 to 9, **characterized in that** the pump radiation source (20) is a pump laser.

11. Semiconductor device according to Claim 10, **characterized in that** the pump laser is an edge-emitting laser.

12. Semiconductor device according to Claim 10 or 11, **characterized in that** the pump laser is a ring laser.

13. Semiconductor device according to one of Claims 10 to 12, **characterized in that** the pump laser has a resonator, and the quantum well structure (11) is arranged within the resonator.

14. Semiconductor device according to one of Claims 1 to 13, **characterized in that** the pump radiation (2) is introduced into the quantum well structure (11) in the lateral direction.

15. Semiconductor device according to one of Claims 1 to 14, **characterized in that** the pump radiation source (20) and the surface-emitting quantum well structure (11) are formed epitaxially and in succession.

16. Semiconductor device according to one of Claims 1 to 15, **characterized in that** the recess (10) is arranged in a grow-in region between the pump radiation source (20) and the surface-emitting quantum well structure (11).

**17.** Semiconductor device according to Claim 16, **characterized in that** the recess (10) is formed by at least partial removal of the grow-in region (19).

**18.** Semiconductor device according to one of Claims 1 to 17, **characterized in that** the pump radiation source (20) has at least one waveguide layer (23, 24).

**19.** Method for fabricating an optically pumped semiconductor device having a semiconductor body which comprises a surface-emitting quantum well structure (11) and at least one pump radiation source (20) which generates pump radiation (2) for optically pumping the quantum well structure (11), the pump radiation source (2) and the quantum well structure (11) being monolithically integrated, comprising the steps of:

> a) providing a substrate (1),
> b) epitaxially growing a plurality of semiconductor layers on to the substrate (1), which layers include the quantum well structure (11),
> c) partially removing the semiconductor layers, and
> d) epitaxially growing the pump radiation source (20) in the region uncovered by the removal in step c) so that the pump radiation source (20) adjoins the quantum well structure (11),

> **characterized in that**
> a recess (10) for introducing the pump radiation (2) into the quantum well structure (11) is formed between the pump radiation source (20) and the quantum well structure (11).

**20.** Method according to Claim 19, **characterized in that** in step d) semiconductor layers are grown in order to form the pump radiation source (20), these layers in a grow-in region (19), at least partially growing together in the lateral direction with the quantum well structure (11), and the recess (10) is formed by at least partial removal of the grow-in region (19).

**21.** Method according to Claim 19 or 20, **characterized in that** the recess (10) is formed by etching, in particular, wet-chemical or dry-chemical etching.

**22.** Method according to one of Claims 19 to 21, **characterized in that** the recess (10) is designed in trench form, in particular as an etched trench.

**23.** Method according to one of Claims 19 to 22, **characterized in that** the recess (10) is filled with a material which transmits the pump radiation.

**24.** Method according to Claim 23, **characterized in that** the recess (10) is filled with silicone or a semiconductor material.

**25.** Method for fabricating an optically pumped semiconductor device having a semiconductor body which comprises a surface-emitting quantum well structure (11) and at least one pump radiation source (20) which generates pump radiation (2) for optically pumping the quantum well structure (11), the pump radiation source (2) and the quantum well structure (11) being monolithically integrated, comprising the steps of:

> a) providing a substrate (1),
> b) epitaxially growing a plurality of semiconductor layers on to the substrate (1), which layers include the pump radiation source (20),
> c) forming a window in the plurality of semiconductor layers for the quantum well structure (11), and
> d) epitaxially growing the quantum well structure (11) in the window so that the pump radiation source (20) adjoins the quantum well structure (11), **characterized in that**

> a recess (10) for introducing the pump radiation (2) into the quantum well structure (11) is formed between the pump radiation source (20) and the quantum well structure (11).

**26.** Method according to Claim 25, **characterized in that** in step d) semiconductor layers are grown in order to form the quantum well structure (11), these layers in a grow-in region, at least partially growing together in the lateral direction with the layer sequence of the pump radiation source (20), and the recess (10) is formed by at least partial removal of the grow-in region (19).

**27.** Method according to Claim 25 or 26, **characterized in that** the recess (10) is formed by etching, in particular, wet-chemical or dry-chemical etching.

**28.** Method according to one of Claims 25 to 27, **characterized in that** the recess (10) is designed in the form of a trench, in particular as an etched trench.

**29.** Method according to one of Claims 25 to 28, **characterized in that** the recess (10) is filled with a material which transmits the pump radiation.

**30.** Method according to Claim 29, **characterized in that** the recess (10) is filled with silicone or a semiconductor material.

**Revendications**

**1.** Dispositif semi-conducteur pompé optiquement, émettant un rayonnement et présentant un corps semi-conducteur doté d'au moins une source (20) de rayonnement de pompage et d'une structure (11) de puits quantique à émission de surface, la source (20) de rayonnement de pompage et la structure (11) de puits quantique étant intégrées monolithiquement, la source (20) de rayonnement de pompage émettant un rayonnement de pompage (2) qui pompe optiquement la structure (11) de puits quantique, la source (20) de rayonnement de pompage et la structure (11) de puits quantique à émission de surface étant formées par des successions différentes de couches semi-conductrice,

**caractérisé en ce que**

une découpe (10) pour l'injection du rayonnement de pompage (2) dans la structure (11) de puits quantique est formée dans le corps semi-conducteur entre la source (20) de rayonnement de pompage et la structure (11) de puits quantique.

2. Dispositif semi-conducteur selon la revendication 1, **caractérisé en ce que** la découpe (10) a la forme d'un sillon et s'étend obliquement ou perpendiculairement par rapport à la direction de propagation du rayonnement de pompage (2).

3. Dispositif semi-conducteur selon les revendications 1 ou 2, **caractérisé en ce que** la découpe (10) présente une première surface latérale (26) tournée vers la source (20) de rayonnement de pompage et une deuxième surface latérale (27) opposée à la première et tournée vers la structure (11) de puits quantique, le rayonnement de pompage (2) pénétrant par la première surface latérale (26) dans la découpe (10) et ensuite par la deuxième surface latérale (27) dans la structure (11) de puits quantique.

4. Dispositif semi-conducteur selon la revendication 3, **caractérisé en ce que** la deuxième surface latérale (27) est parallèle à la première surface latérale (26).

5. Dispositif semi-conducteur selon les revendications 3 ou 4, **caractérisé en ce que** la première et/ou la deuxième surface latérale (26, 27) forment un angle égal à l'angle de Brewster avec la direction de propagation du rayonnement de pompage (2) et en particulier avec la direction d'émission principale de la source (20) de rayonnement de pompage.

6. Dispositif semi-conducteur selon l'une des revendications 1 à 5, **caractérisé en ce que** la découpe (10) est remplie d'un diélectrique ou d'un matériau semi-conducteur.

7. Dispositif semi-conducteur selon la revendication 6, **caractérisé en ce que** la découpe (10) est remplie d'un matériau dont l'indice de réfraction est essentiellement égal à l'indice de réfraction de la source (2) de rayonnement de pompage, à l'indice de réfraction de la structure (11) de puits quantique ou à la moyenne géométrique entre ces deux indices de réfraction.

8. Dispositif semi-conducteur selon l'une des revendications 1 à 7, **caractérisé en ce que** le dispositif semi-conducteur comporte un émetteur vertical doté d'une partie émettrice de rayonnement formée par la structure (11) de puits quantique.

9. Dispositif semi-conducteur selon la revendication 8, **caractérisé en ce que** l'émetteur vertical est un laser à émission verticale, en particulier un VCSEL ou un laser en plaque.

10. Dispositif semi-conducteur selon l'une des revendications 1 à 9, **caractérisé en ce que** la source (20) de rayonnement de pompage est un laser pompé.

11. Dispositif semi-conducteur selon la revendication 10, **caractérisé en ce que** le laser pompé est un laser émettant par les bords.

12. Dispositif semi-conducteur selon les revendications 10 ou 11, **caractérisé en ce que** le laser pompé est un laser annulaire.

13. Dispositif semi-conducteur selon l'une des revendications 10 à 12, **caractérisé en ce que** le laser pompé présente un résonateur et **en ce que** la structure (11) de puits quantique est disposée à l'intérieur du résonateur.

14. Dispositif semi-conducteur selon l'une des revendications 1 à 13, **caractérisé en ce que** le rayonnement de pompage (2) est injecté dans la direction latérale de la structure (11) de puits quantique.

15. Dispositif semi-conducteur selon l'une des revendications 1 à 14, **caractérisé en ce que** la source (20) de rayonnement de pompage et la structure (11) de puits quantique à émission de surface sont formées par épitaxie et successivement.

16. Dispositif semi-conducteur selon l'une des revendications 1 à 15, **caractérisé en ce que** la découpe (10) est disposée dans une zone de croissance située entre la source (20) de rayonnement de pompage et la structure (11) de puits quantique à émission de surface.

17. Dispositif semi-conducteur selon la revendication 16, **caractérisé en ce que** la découpe (10) est formée par l'enlèvement d'au moins une partie de la zone de croissance (19).

18. Dispositif semi-conducteur selon l'une des revendications 1 à 17, **caractérisé en ce que** la source (20) de rayonnement de pompage présente au moins une couche (23, 24) de guidage d'onde.

19. Procédé de fabrication d'un dispositif semi-conducteur qui présente un corps semi-conducteur doté d'une structure (11) de puits quantique à émission de surface et d'au moins une source (20) de rayonnement de pompage qui émet le rayonnement de pompage (2) pour pomper optiquement la structure (11) de puits quantique, la source (2) de rayonnement de pompage et la structure (11) de puits quantique étant intégrées monolithiquement, le procédé comportant les étapes qui consistent à :

    a) préparer un substrat (1),
    b) faire croître par épitaxie sur le substrat (1) plusieurs couches semi-conductrices qui contiennent la structure (11) de puits quantique,
    c) enlever une partie des couches semi-conductrices et
    d) faire croître par épitaxie la source (20) de rayonnement de pompage dans la partie libérée par l'enlèvement de l'étape c), de telle sorte que la source (20) de rayonnement de pompage devienne adjacente à la structure (11) de puits quantique, **caractérisé en ce que**

une découpe (10) pour l'injection du rayonnement de pompage (2) dans la structure (11) de puits quantique est formée entre la source (20) de rayonnement de pompage et la structure (11) de puits quantique.

20. Procédé selon la revendication 19, **caractérisé en ce que** pour former la source (20) de rayonnement de pompage à l'étape d), on fait croître dans une zone de croissance (19) des couches semi-conductrices qui croissent dans la direction latérale, au moins en partie conjointement avec la structure (11) de puits quantique, la découpe (10) étant formée par l'enlèvement d'au moins une partie de la zone de croissance (19).

21. Procédé selon les revendications 19 ou 20, **caractérisé en ce que** la découpe (10) est formée par gravure, en particulier par gravure chimique en conditions humides ou gravure chimique à sec.

22. Procédé selon l'une des revendications 19 à 21, **caractérisé en ce que** la découpe (10) a la forme d'un sillon et en particulier d'un sillon gravé.

23. Procédé selon l'une des revendications 19 à 22, **caractérisé en ce que** la découpe (10) est remplie d'un matériau transparent pour le rayonnement de pompage.

24. Procédé selon la revendication 23, **caractérisé en ce que** la découpe (10) est remplie de silicium ou d'un matériau semi-conducteur.

25. Procédé de fabrication d'un dispositif semi-conducteur qui présente un corps semi-conducteur doté d'une structure (11) de puits quantique à émission de surface et d'au moins une source (20) de rayonnement de pompage qui émet le rayonnement de pompage (2) pour pomper optiquement la structure (11) de puits quantique, la source (2) de rayonnement de pompage et la structure (11) de puits quantique étant intégrées monolithiquement, le procédé comportant les étapes qui consistent à :

    a) préparer un substrat (1),
    b) faire croître par épitaxie sur le substrat (1) plusieurs couches semi-conductrices qui contiennent la source (20) de rayonnement de pompage,
    c) former dans les différentes couches semi-conductrices une fenêtre pour la structure (11) de puits quantique et
    d) faire croître par épitaxie la structure (11) de puits quantique dans la partie libérée par l'enlèvement de l'étape c), de telle sorte que la source (20) de rayonnement de pompage devienne adjacente à la structure (11) de puits quantique, **caractérisé en ce que**

une découpe (10) d'injection du rayonnement de pompage (2) dans la structure (11) de puits quantique est formée entre la source (20) de rayonnement de pompage et la structure (11) de puits quantique.

26. Procédé selon la revendication 25, **caractérisé en ce que** pour former la structure (11) de puits quantique à l'étape d), on fait croître dans une zone de croissance des couches semi-conductrices qui croissent dans la direction latérale, au moins en partie conjointement avec la succession de couches de la source (20) de rayonnement de pompage, la découpe (10) étant formée par l'enlèvement d'au moins une partie de la zone de croissance (19).

27. Procédé selon les revendications 25 ou 26, **caractérisé en ce que** la découpe (10) est formée par gravure, en particulier par gravure chimique en conditions humides ou gravure chimique à sec.

28. Procédé selon l'une des revendications 25 à 27, **caractérisé en ce que** la découpe (10) a la forme d'un sillon et en particulier d'un sillon gravé.

29. Procédé selon l'une des revendications 25 à 28, **caractérisé en ce que** la découpe (10) est remplie d'un matériau transparent pour le rayonnement de pompage.

**30.** Procédé selon la revendication 29, **caractérisé en ce que** la découpe (10) est remplie de silicium ou d'un matériau semi-conducteur.

## FIG 1A

## FIG 1B

# FIG 2

FIG 3

## FIG 4A

## FIG 4B

## FIG 4C

## FIG 4D

## FIG 4E

## FIG 4F

## FIG 5

## FIG 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10026734
- US 5748653 A
- US 20020075935 A